(19)

Europäisches
Patentamt
European
Patent Office
Office européen
des brevets

(11) **EP 2 664 896 A1**

(12) **EUROPEAN PATENT APPLICATION**
published in accordance with Art. 153(4) EPC

(43) Date of publication:
**20.11.2013 Bulletin 2013/47**

(21) Application number: **12708877.1**

(22) Date of filing: **13.01.2012**

(51) Int Cl.:
***G01D 3/036*** (2006.01)

(86) International application number:
**PCT/ES2012/070018**

(87) International publication number:
**WO 2012/095546 (19.07.2012 Gazette 2012/29)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **14.01.2011 ES 201130037**

(71) Applicant: **EADS Construcciones Aeronauticas,
S.A.
28022 Madrid (ES)**

(72) Inventor: **LORENZO PEÑA, Eladio
E-28047 Madrid (ES)**

(74) Representative: **Elzaburu Marquez, Alberto
Elzaburu, S.L.P.
C/ Miguel Ángel, 21
28010 Madrid (ES)**

(54) **DEVICE FOR RENDERING ELECTRICAL SIGNALS HIGHLY IMMUNE TO NOISE**

(57) Device for providing electrical signals with high immunity to noise. The invention develops a device for processing electrical signals (100) coming from a measurement sensor (60), said sensor (60) being subjected to noise disturbances caused by radio interference and lightning effects, such that said device uses a single current-loop cable (70), through which passes the electrical signal (100) encoded according to the signal time (Ta) and repetition time (Tr) of the current wave of said signal (100), such that said signal (100) contains an upper current state (10) and a lower current state (20) whose values are outside the decision window that activates a reading device (4) in the device, which reads the electrical signal (100) coming from the sensor.

FIG. 1

EP 2 664 896 A1

**Description**

**SCOPE OF THE INVENTION**

This invention relates to a device for providing electrical signals in critical high-disturbance areas with high immunity to noise, preferably electrical signals originating from a measurement sensor situated in a critical zone of an aircraft.

**BACKGROUND**

In aircraft it is necessary to take various measurements in specific zones of the aforementioned aircraft, which is often carried out using sensors, which are devices capable of detecting physical or chemical magnitudes (known as instrumentation variables) and turning them into electrical variables, such as electrical resistance, electrical capacity, electrical voltage or electrical current. Thus, the sensor is always in contact with the instrumentation variable it is detecting, adapting the signal measured so that it can be interpreted by another device which may not be in the same place as the sensor, in which case we speak of remote sensors.

Therefore, a sensor is a device that transforms the magnitude to be measured or monitored (instrumentation variable) into a different one, facilitating its measurement. In general, the output signal of a sensor is not suitable for direct reading, nor occasionally for processing, so a conditioning circuit or conditioner is often used for the output signal of the sensor: this conditioning circuit usually includes electronic filters and amplifiers, which adapt the sensor signal to levels and bandwidths suitable for the rest of the circuit.

Many of the sensors in aircraft are installed in zones highly exposed to high-power radio interference and the effects of lightning, such that these sensors suffer major disturbances and their measurement error ratio is high. In this context, noise means all disturbances that may be induced in electrical signals due to effects radiated, conducted or induced by all manner of external signals, including lightning. If these sensors are part of systems deemed to be critical for aircraft safety, it is particularly desirable to provide a device that enables said remote sensor to be read simply and with minimal error, such that said device is provided with very high immunity to noise.

The systems currently used require, in the case of remote sensors in critical zones of the aircraft, in which measurements must be taken with a minimal margin of error and in which potential errors are detected in system components, the use of highly complex systems or devices, with the consequent increase in maintenance work, which is even greater if reliability needs to be increased, which requires the use of redundant devices.

This invention is intended to resolve the above drawbacks.

**SUMMARY OF THE INVENTION**

Therefore, this invention relates to a device for providing electrical signals coming from a remote sensor, preferably installed in an aircraft, with high noise immunity, such that said sensor measures and monitors specific physical magnitudes of the aforementioned aircraft: the sensor comprises a signal transducer, which is used to transform the aforementioned physical magnitudes from the aircraft into electrical magnitudes so that they can be processed and measured by said sensor. For example, this signal transducer comprises a Wheatstone bridge (electrical measurement instrument used to measure unknown resistances by balancing the legs of the bridge), or a piezoelectric sensor.

In particular, the remote sensors mentioned can be found very close (centimetres away) to specific zones of the aircraft with high exposure to high-power radio interference and lightning effects, such that these sensors suffer major noise disturbances. It is also possible, especially in the field of aircraft, which involves substantial distances (for example, several tens of metres), that these remote sensors are connected with the reading device by means of a long connecting cable (twisted pair), the noise generating high levels of disturbance in the signal transmitted by said cable. In all of the cases mentioned, it is necessary to provide a device such as the one according to the invention, that is capable of providing the electrical signals coming from the remote sensor with high noise immunity.

Thus, the device according to the invention comprises the following elements:

- a power source, which provides constant voltage to power the sensor and the rest of the components of the device, while maintaining the constant load to determine the zero reference state of the device and to determine the state in which the device is operating at any given time;
- a conditioning device for the output signal of the sensor, which adapts the sensor signal to levels appropriate to the remainder of the device;
- an output signal modulation device of the conditioning device; and
- a reading device for the output signal coming from the modulation device.

Thus, in the device according to the invention, a current loop is established, which in addition to powering the sensor, enables us to determine the data that this is generating, the data being sent from the remote sensor through a single cable (twisted pair), said data being time encoded, such that only two current states are sent, upper state and lower state, this lower state being determined by the minimum power draw of the sensor.

The device according to the invention is therefore able to ensure, by appropriately selecting the values of the upper and lower current states, that the noise (disturbance) only affects the rising and falling edges of the cable current, given that the stable current states (upper and lower states) are selected outside the limits of the decision window of the reading device, so that noise in any of said states does not affect the measurement taken by the device, as it is not possible for any change to occur in the state of the current. Therefore, the signal-to-noise ratio in the current wave of the device according to the invention depends on the time required for the wave to reach the upper state, plus the time required for the wave to reach the lower state, and the wave repetition time.

As the value of the measured signal is proportional to the time it is active, with respect to its repetition time, according to another embodiment of the invention, when the wave repetition time is constant the device is further simplified, given that in this case the reading device only needs to determine the time between the rising edge and the falling edge of the current wave.

Other characteristics and advantages of this invention are set out in the detailed description given below in relation to the attached figures.

## DESCRIPTION OF FIGURES

Figure 1 is a voltage-time graph for the current wave passing through the device according to the invention.
Figure 2 shows the elements that make up the conditioning device for the output signal of the sensor of the device according to the invention.
Figure 3 shows the elements that make up the modulation device for the output signal of the conditioning device in the device according to the invention.
Figure 4 shows the elements that make up the reading device for the output signal coming from the modulation device in the device according to the invention.
Figure 5 shows in detail the digital signal processor of the reading device in Figure 4.
Figure 6 is a schematic representation of the layout of the device according to the invention in relation to the remote measurement sensor.

## DETAILED DESCRIPTION OF THE INVENTION

The invention develops a device for providing high noise immunity for electrical signals coming from a remote sensor, preferably arranged in an aircraft, noise meaning primarily high-power radio interference and the effects of lightning.

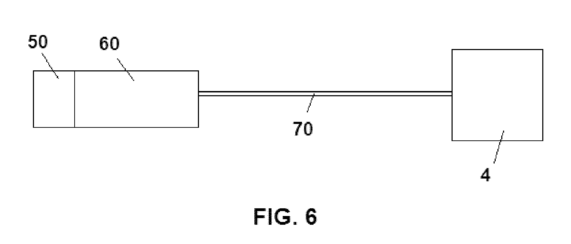

As shown in Figure 6, the remote sensor 60 comprises a signal transducer 50, which is used to transform the physical magnitudes from the aircraft into electrical magnitudes, which physical magnitudes are processed and measured by said sensor 60.

The device according to the invention comprises the following elements:

- a power source 1, which provides constant voltage to power the sensor and the rest of the components of the device, while maintaining the constant load to determine the zero reference state of the device;
- a conditioning device 2 for the output signal of the sensor, which adapts the sensor signal to levels appropriate to the remainder of the device;
- a device 3 for modulating the output signal of the conditioning device to a discrete signal in which the data resides in the time that said signal is active in relation to its repetition time; and
- a reading device 4 for the output signal coming from the modulation device 3.

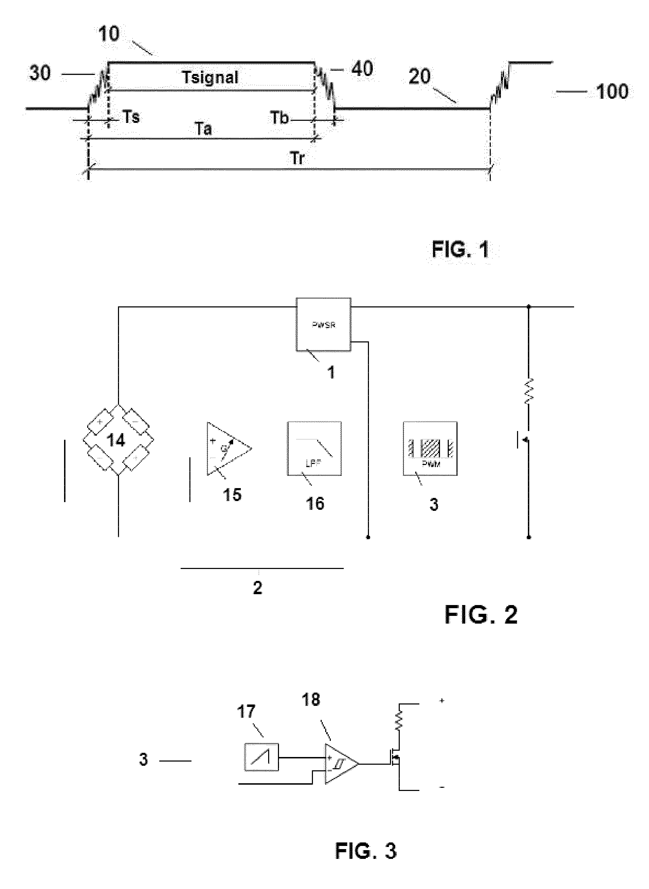

Therefore, in the device according to the invention, a current loop is established, by means of a single cable (twisted pair) 70, said data being time encoded, such that only two current states are sent, upper state 10 and lower state 20 (see Figures 1 and 6).

The device ensures, by selecting the values of the upper 10 and lower 20 current states, that the noise only affects the rising 30 and falling 40 edges of the cable current, given that the stable current states 10 and 20 are such that they exceed the limits of the decision window of the reading device 4.

The ratio between the signal S and the noise N in the current wave 100 of the current loop depends on the time required for the wave to reach the upper state (rising time Ts), the time required for the wave to reach the lower state (falling time Tb), and the wave repeat time (Tr), as shown in Figure 1.

In this way, by appropriately selecting the current values 10 and 20, the noise N will only affect the rising 30 and falling 40 edges, because in the stable states 10 and 20 it will not exceed the activation limits of the reading device 4, as a result of which the signal/noise ratio (S/N) that can be obtained will be the ratio between the sum of the rising time (Ts) plus the falling time (Tb) and the wave repetition time (Tr), which in general will make it possible to achieve 60 dB fairly easily, a value which corresponds to a device precision of 0.001, in other words, the noise only has an influence in 1/1000 cases.

$$S = Ta / Tr \quad Min \ S/N=(Ts+Tb)/Tr$$

Where Ta is the activation time of the wave, as shown in Figure 1.

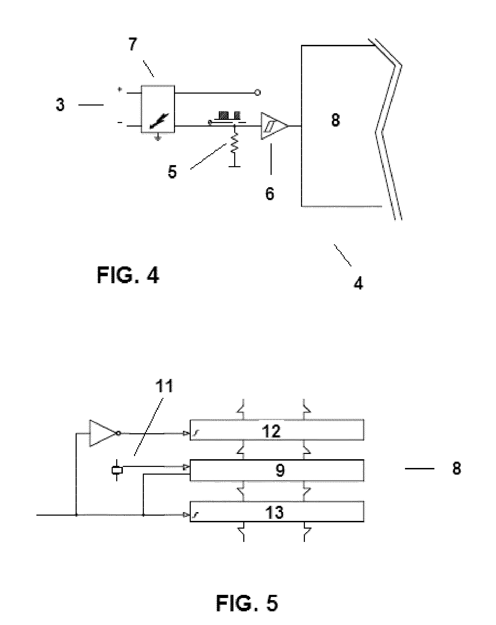

The signal is also recovered very simply by the reading device 4, as detailed in Figures 4 and 5: therefore, the reading device 4 comprises a filter 7 to prevent any damage caused by lightning discharges in said reading device 4, a resistor 5 that converts the current into voltage, a trigger 6 to read with absolute stability both current states, 10 and 20, and a digital signal processor 8 or a microcontroller. The digital signal processor 8, as shown in Figure 5, will have a counter 9 that measures the time between the rising edge Ts and the falling edge Tb of the signal, which will be kept in a latch 12, which is activated to indicate the end of the active signal (falling edge 40), and in another latch 13, which is activated with each start of the active signal (rising edge 30). Moreover the counter 9 will be reset with this edge once the data has been stored in the latch 13.

Therefore the value of the signal measured in the reading device 4 will be the ratio between the value obtained in the first latch 12 and the one obtained in the second latch 13, which is the repetition time, Tr.

The power source 1 of the device has the dual function of providing a constant voltage to power the sensor and the remaining electronics of the components of the device, while maintaining the constant load which determines the zero state of the current loop, by means of dual feedback of the source 1. According to another embodiment of the invention, the above may be achieved without the need to keep the load of the power source 1 constant, by using in this case a high-pass filter in the reading device 4.

The conditioning device 2 for the output signal of the sensor, for example, a Wheatstone bridge 14, comprises an amplifier 15 and a filter 16, generally low-pass or band-pass (see Figure 2), which condition the signal of the Wheatstone bridge 14 to values that both in voltage, and in bandwidth, are ideal for the modulation device 3. The modulation device 3 generates a change of state that results in an increase in draw of the current loop such that the time that this state lasts is proportional to the voltage obtained from the sensor. The above is achieved by means of a ramp generator 17 and a trigger 18: the trigger 18 changes state when the ramp voltage supplied by the ramp generator 17 is greater than the value of the voltage signal obtained from the sensor, such that the time it takes the trigger 18 to change state from the time the period starts is proportional to the voltage of the conditioned signal Ta (see Figure 3). The ramp generator 17 may be implemented, either analogically (with a current generator and a trigger that determines the repetition time Tr) or digitally (with a counter and an analogue digital converter), with the relative advantages and drawbacks, but again in all cases very simply.

The value calculated by the device, as the output of the reading device 4, will be:

$$Ta= k * Signal$$

$$Tr= k * Max \ signal$$

$$S=Cal* \ Signal/Period = Cal*Ta/Tr$$

Where *Cal* is the ratio for converting the signal into physical units.

According to another embodiment of the invention, operation of the device may be further simplified by ensuring that the wave repetition time Tr has a constant value: in this case, the reading device need only read the time that determines the value of the current signal, Ta, i.e., the time between the rising edge 30 and the falling edge 40 (see Figure 1). To achieve said functionality, the oscillator 11 of the digital signal processor 8 must be precise enough to ensure that its maximum deviations, due to ambient operating conditions, are not representative in the final precision required, or at least are included in the total error calculation, since these potential variations modify the relative position of the rising edge 30, in the same way as noise would, and may be considered to be noise.

Moreover, another of the advantages of the device according to the invention is that it implicitly includes, in the way it sends the current signal, two very simple ways of determining the possible failure modes in said device (by open circuit, by short-circuit, by connection to earth or by failure of a component in the device itself):

1. One of these advantages derives from the fact that the logic state intensity 0 makes it possible to determine any of the potential failure modes mentioned above simply by using analogue voltage comparators, since their normal operating value must be within certain limits, which will be passed, above or below, if there is an open circuit, if the current does not reach the receiver, in the event of a short-circuit, if the current is much greater than the maximum current set, in the event of connection to earth, if the current does not reach the receiver, and as a result of potential failure of any of the components of the sensor that would cause changes in the current similar to the situations mentioned above;

2. The other advantage consists of checking that the counter 9 of the digital signal processor 8 never overflows (if this were to happen, a fault would have occurred), given that counter 9 includes a clock that is chosen such that said counter 9 is close to its limit for the period to be measured, in order to provide maximum precision; if the counter 9 overflows, this would indicate that the period is greater than it ought to be in normal operation, which indicates that a fault has occurred.

Therefore, the principal advantage achieved with the device according to the invention is that it is practically free of charge to determine that the sensor has failed, which is what is required when a system is considered to be critical for flight safety; in other words, the device according to the invention makes it possible to determine that the signal being read is valid given that, if it is not, as the device will normally be redundant, said invalid signal is overridden and decisions are taken using valid data.

In this way, the device according to the invention provides a redundant and independent fault detection system, and moreover has a minimum number of components to achieve said functionality: the system is redundant because the determination of a possible fault is measured in two different ways, with both always being used in the event of a potential failure; one of them is effected using signal comparators (case *1* cited above), and the second which indicates a potential failure by detecting that a period of time has been exceeded (case 2 above). The fact that the functionalities required are provided with a minimal number of components, means that the device according to the invention is more reliable (a greater number of components increases the possibility of error and distortion in the measurement), with minimal weight.

By way of summary, the device according to this invention has the following fundamental advantages and characteristics:

- It is a device valid for any type of remote sensor that transforms a measured physical magnitude into an electrical magnitude or signal 100;
- The device according to the invention is simple to implement, and as a result it is simple to determine, using few components, whether it is operating correctly;
- The device according to the invention is powered by a single cable, which is also used to transmit the data from the sensor which is processed by said device;
- The device according to this invention is highly immune to noise, since the data that the device receives, which is actually data relating to a change of state that has occurred, is in the rising edges 30 and falling edges 40 of the electrical signal 100 coming from the sensor, this signal 100 having moreover only two stable current states, an upper state 10 and a lower state 20, which means that, if the rising and falling edges, 30 and 40, are rapid, the noise has very little influence on the electrical signal 100 processed by the device.

In this way, in the device according to the invention, a current loop is established, which in addition to powering the sensor, enables us to determine the data that this generates, the data being sent from the remote sensor via a single cable (twisted pair),

Although this invention has been described in full in relation to the preferred embodiments, it is evident that modifications made are made within the scope of the following claims, which is not limited by the above embodiments.

**Claims**

1. Device for processing electrical signals (100) coming from a measurement sensor (60), said sensor (60) being subjected to noise disturbances caused by radio interference and lightning effects, such that said device uses a single current-loop cable (70), through which passes the electrical signal (100) encoded according to the signal time (Ta) and repetition time (Tr) of the current wave of said signal (100), such that said signal (100) contains an upper current state (10) and a lower current state (20) whose values are outside the decision window that activates a reading device (4) in the device, which reads the electrical signal (100) coming from the sensor.

2. Device for processing electrical signals (100) coming from a measurement sensor (60), according to Claim 1, such that said sensor (60) is a remote sensor.

3. Device according to either one of Claims 1-2 that includes a power source (1), which provides constant voltage to power the sensor (60) and the remainder of the components of the device, keeping the load of the source (1) constant by means of dual feedback in said source (1).

4. Device according to either one of Claims 1-2 that includes a power source (1), and a high-pass filter in the reading device (4).

5. Device according to any one of the above claims, that also includes a conditioning device (2) for the output signal of the sensor (60), that in turn comprises an amplifier (15) and a filter (16) to adapt the sensor signal to levels appropriate to the rest of the device.

6. Device according to Claim 5, which also includes a device (3) for modulating the output signal of the conditioning device (2) to a discrete signal in which the data resides in the time that the signal (Ta) is active in relation to the repetition time (Tr) of the current wave of said signal (100).

7. Device according to any one of the above claims, in which the reading device (4) reads the electrical signal (100) coming from the sensor (60), which includes a resistor (5) that converts the current into voltage, a trigger (6) to read the two current states (10, 20) and a digital signal processor (8) or a microcontroller.

8. Device according to Claim 7, in which the digital signal processor (8) includes a counter (9) that measures the signal time (Ta) against the repetition time (Tr) of the wave of the electrical signal (100), a latch (12) that indicates the end of the active signal, and a latch (13) that indicates the repetition period, as well as initialising the counter (9).

9. Device according to any one of the above claims, in which the repetition time (Tr) of the wave of the electrical signal (100) is constant, such that the reading device (4) reads the time that determines the value of the current signal (Ta).

10. Device according to any one of the above claims, in which it is determined in real time that the sensor is working correctly using several analogue voltage comparators that determine whether the current received by the device is within certain set limits.

11. Device according to any one of the above claims, in which the sensor is placed in an aircraft.

**FIG. 1**

**FIG. 2**

**FIG. 3**

FIG. 4

FIG. 5

50    60

70

4

FIG. 6

# EP 2 664 896 A1

## INTERNATIONAL SEARCH REPORT

| International application No |
|---|
| PCT/ES2012/070018 |

**A. CLASSIFICATION OF SUBJECT MATTER**
INV. G01D3/036
ADD.

According to International Patent Classification (IPC) or to both national classification and IPC

**B. FIELDS SEARCHED**

Minimum documentation searched (classification system followed by classification symbols)
G01D

Documentation searched other than minimum documentation to the extent that such documents are included in the fields searched

Electronic data base consulted during the international search (name of data base and, where practicable, search terms used)
EPO-Internal, WPI Data

**C. DOCUMENTS CONSIDERED TO BE RELEVANT**

| Category* | Citation of document, with indication, where appropriate, of the relevant passages | Relevant to claim No. |
|---|---|---|
| A | US 7 358 880 B1 (MELANSON JOHN L [US]) 15 April 2008 (2008-04-15) abstract; claims 1-4; figure 1 column 1, line 15 - column 2, line 44 ----- | 1-11 |
| A | EP 0 965 819 A1 (VIBRO METER AG [CH]) 22 December 1999 (1999-12-22) abstract; claims 1-3; figure 1 paragraph [0002] - paragraph [0004] ----- | 1-11 |

☐ Further documents are listed in the continuation of Box C.     ☒ See patent family annex.

* Special categories of cited documents :

"A" document defining the general state of the art which is not considered to be of particular relevance

"E" earlier application or patent but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step when the document is taken alone

"Y" document of particular relevance; the claimed invention cannot be considered to involve an inventive step when the document is combined with one or more other such documents, such combination being obvious to a person skilled in the art

"&" document member of the same patent family

| Date of the actual completion of the international search | Date of mailing of the international search report |
|---|---|
| 14 June 2012 | 26/06/2012 |

| Name and mailing address of the ISA/ European Patent Office, P.B. 5818 Patentlaan 2 NL - 2280 HV Rijswijk Tel. (+31-70) 340-2040, Fax: (+31-70) 340-3016 | Authorized officer Katerbau, Ragnar |
|---|---|

Form PCT/ISA/210 (second sheet) (April 2005)

10

## INTERNATIONAL SEARCH REPORT
Information on patent family members

International application No

PCT/ES2012/070018

| Patent document cited in search report | | Publication date | Patent family member(s) | | Publication date |
|---|---|---|---|---|---|
| US 7358880 | B1 | 15-04-2008 | EP | 2109779 A1 | 21-10-2009 |
| | | | US | 7358880 B1 | 15-04-2008 |
| | | | WO | 2008098067 A1 | 14-08-2008 |
| EP 0965819 | A1 | 22-12-1999 | CA | 2272166 A1 | 16-12-1999 |
| | | | DE | 69825429 D1 | 09-09-2004 |
| | | | DE | 69825429 T2 | 13-01-2005 |
| | | | DK | 965819 T3 | 13-12-2004 |
| | | | EP | 0965819 A1 | 22-12-1999 |
| | | | ES | 2226088 T3 | 16-03-2005 |
| | | | US | 6107881 A | 22-08-2000 |

Form PCT/ISA/210 (patent family annex) (April 2005)